# EUROPÄISCHE PATENTSCHRIFT

(11) **EP 1 214 741 B1**
(45) Veröffentlichungstag und Bekanntmachung des Hinweises auf die Patenterteilung: **02.02.2005**
(21) Anmeldenummer: 00963990.7
(22) Anmeldetag: 20.09.2000
(51) Int. Cl.: H01L 23/367

(54) **STEUERGERÄT, INSBESONDERE FÜR DIE KRAFTFAHRZEUGTECHNIK**
CONTROL DEVICE, PARTICULARLY FOR USE IN AUTOMOTIVE ENGINEERING
APPAREIL DE COMMANDE, NOTAMMENT POUR APPLICATIONS AUTOMOBILES

(30) Priorität: 22.09.1999 DE 19945428
(43) Veröffentlichungstag der Anmeldung: 19.06.2002
(60) Teilanmeldung: 04005427.2
(73) Patentinhaber: SIEMENS AKTIENGESELLSCHAFT, 80333 München (DE)
(72) Erfinder: MAURER, Thomas, D-93059 Regensburg (DE); HAUPT, Detlef, D-93128 Regenslauf (DE)
(86) Internationale Anmeldenummer: PCT/DE2000/003275
(87) Internationale Veröffentlichungsnummer: WO 2001/022489

(56) Entgegenhaltungen:
- EP-A- 0 124 029
- DE-A- 19 532 992
- US-A- 4 509 096
- US-A- 5 459 639
- US-A- 5 646 826
- PATENT ABSTRACTS OF JAPAN vol. 1998, no. 06, 30. April 1998 (1998-04-30) -& JP 10 032291 A (OKI ELECTRIC IND CO LTD), 3. Februar 1998 (1998-02-03)

## Beschreibung

Die Erfindung betrifft ein Steuergerät nach dem Oberbegriff von Anspruch 1. Solche Steuergeräte sind insbesondere für den Einsatz in Kraftfahrzeugen vorgesehen. Sie weisen in der Regel mehrere elektrische und elektronische Bauelemente auf, in denen beim Betrieb des Steuergeräts Verlustwärme erzeugt wird. Diese Wärme muss wirksam abgeführt werden, wenn die hoch belasteten Bauelemente nicht zerstört werden sollen.

Bei einem bekannten elektrischen Gerät ist ein thermisch hochbelastetes Bauelement durch eine Wärmeleitbrücke in Form eines länglichen Metallkörpers oder Kupferbolzens mit einer Kühlplatte verbunden (DE 195 32 992 A1). Der Kupferbolzen ist verzinnt und wird mit dem Bauelement verlötet.

Der Kupferbolzen weist auf seiner dem Bauelement zugewandten Seite eine glatte Oberfläche auf. Unter besonderen Umständen kann die mit dem Bauelement verbundene Oberfläche des Kupferbolzens nicht ausreichen, um genügend Wärme abzuführen.

Der Erfindung liegt das technische Problem zugrunde, ein Steuergerät zu schaffen, in dem die Wärmeabfuhr auch bei hoher Belastung des oder der Bauelemente ausreichend ist, d. h. in dem bei gegebener Größe des wärmeabführenden Metallteils die Wärmeabfuhr erhöht ist.

Ein wärmeabführendes Metallteil mit erhöhter wärmeabfuhr aufgnund seiner vergrößerten Oberfläche ist bekannt aus der US-A-5,459,639.

Das genannte technische Problem wird durch ein Steuergerät nach Anspruch 1 gelöst. Dabei weist die dem Bauelement zugewandte Stirnfläche eine ihre Oberfläche vergrößernde Gestalt auf. Sie ist nach außen gewölbt und kann zusätzlich mit einer Riffelung versehen sein. Das als Wärmebrücke dienende längliche Metallteil kann als Niet, insbesondere als Kupferniet ausgebildet sein.

Die Vorteile der Erfindung liegen insbesondere darin, dass der prozentuale Anteil der Lötfläche an dem wärmeabführenden Gesamtvolumen erhöht ist. Insbesondere wird eine Verbesserung und Optimierung des Lötprozesses erzielt. Durch die Gestalt der verlöteten Stirnfläche wird eine Luftblasenbildung in dem Lötzinn erheblich verringert. Dies erhöht wiederum die Wärmeabfuhr.

Ausführungsbeispiele der Erfindung werden im folgenden anhand der Zeichnung erläutert. Es zeigen:
- Figur 1: ein Steuergerät gemäß der Erfindung in schematischer Darstellung,
- Figur 2: ein zweites Ausführungsbeispiel der Erfindung, und
- Figur 3: ein Steuergerät gemäß dem Stand der Technik.

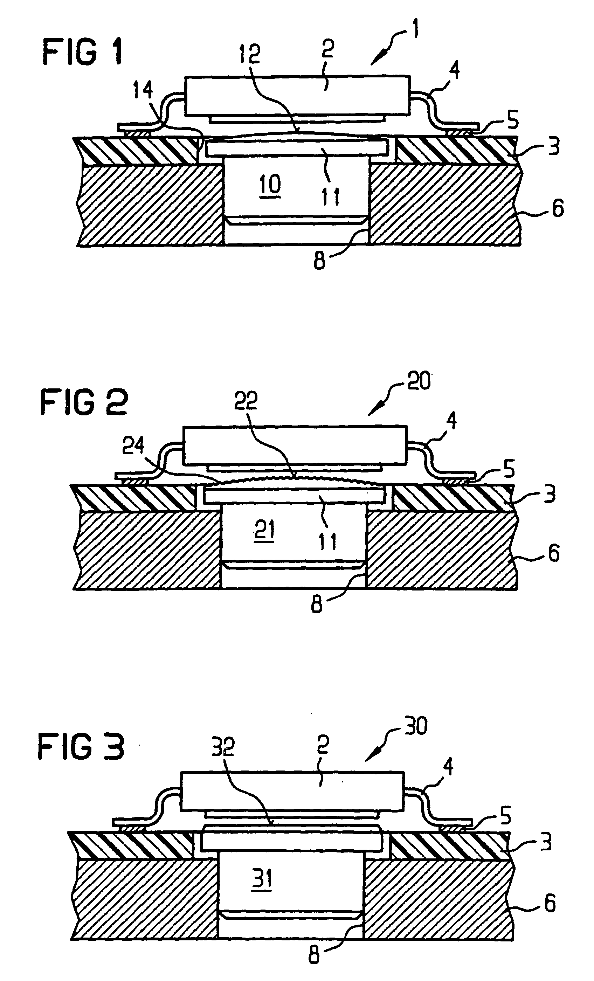

Ein Steuergerät 1 (Figur 1) für ein Kraftfahrzeug besteht im wesentlichen aus einer mit einer Anzahl von elektrischen und/oder elektronischen Bauelementen 2 bestückten Leiterplatte 3. Das Bauelement kann zum Beispiel als oberflächenmontierbares Bauelement (SMD) ausgebildet sein. Ein solches Steuergerät 1 wird in vielzähligen Ausführungen eingesetzt, zum Beispiel zum Steuern von Antiblockiersystemen (ABS) oder als Motor-, Getriebe-, Brems-, Klima-Steuergeräte usw.

Da derartige Steuergeräte für sich bekannt sind, wird in der Zeichnung nur ein Teil des Steuergeräts 1 dargestellt, der zum Erläutern der Erfindung ausreicht. Bekannte weitere Einzelheiten, wie die Verbindungen zur Stromversorgung und zu dem im Einzelfall zu steuernden Gerät sind nicht dargestellt.

Das Bauelemente 2 weist Anschlußdrähte 4 auf, die durch zwei Lötstellen 5 mit Leiterbahnen elektrisch verbunden ist, die auf der Leiterplatte 3 in bekannter Weise verlaufen. Die Leiterplatte 3 ist auf einer metallischen Grund- oder Trägerplatte 6 angeordnet, die zum Beispiel aus Aluminium besteht. Wegen ihrer guten Wärmeleitfähigkeit und ihrer großen Masse ist die Grundplatte sehr gut als Wärmesenke zum Abführen von in dem Steuergerät erzeugter Verlustwärme geeignet.

In einer Bohrung 8 in der Grundplatte 6 steckt ein längliches Metallteil 10, das hier als Kupferniet ausgebildet ist. An seinem in der Zeichnung oben liegenden Ende weist der Niet einen Nietkopf 11 auf, dessen dem Bauelement 2 zugewandte Stirnfläche 12 mit dem Bauelement verlötet wird. In der Zeichnung ist das Steuergerät 1 in dem Zustand vor dem endgültigen Verlöten dargestellt. Der Nietkopf 11 ragt durch eine Bohrung 14 in der Leiterplatte 3 hindurch, deren Durchmesser etwas größer als der Durchmesser des Nietkopfs ist.

Die Stirnfläche 12 von Figur 1 weist eine gegenüber der Stirnfläche 32 eines bekannten Kupferbolzens 31 (siehe Figur 3) dadurch vergrößerte Oberfläche auf, dass sie nach außen gewölbt oder ballig ausgebildet ist. Dadurch ist die mit dem Bauelement 2 zu verlötende Oberfläche größer, was zu einer Verbesserung des Wärmeflusses führt. Die in dem Bauelement verursachte Verlustwärme fließt über die Stirnfläche 12 und den Nietkopf 11 in das längliche Metallteil 10 und von diesem in die Grundplatte 6, mit dem das längliche Metallteil, und genauer der Umfang seiner Längsachse, in enger Berührung steht. Es erfolgt eine Wärmeableitung über einen peripheren Kontakt des Metallteils mit der Grundplatte 6. Das Metallteil weist im wesentlichen entlang seiner gesamten kreisförmigen Umfangslinie einen Berührungskontakt zu der Grundplatte auf.

Wegen der gewölbten Form der Stirnfläche 12 kann das Lot beim Löten leicht nach außen abfließen, wodurch einer Bildung von Luftblasen in dem Lot stark entgegengewirkt wird. Dadurch wird der Wärmeabfluss und damit die Kühlung des Bauelements weiter verbessert.

Bei einem zweiten Ausführungsbeispiel eines Steuergeräts 22 (Figur 2) ist die Stirnfläche nach außen gewölbt und außerdem geriffelt, d. h. mit einer Riffelung 24 versehen. Durch diese Riffelung 24 wird die von dem Lot zu benetzende Oberfläche und die Lotmenge noch größer und damit auch der Wärmefluss weiter erhöht. Durch die Riffelung auf der balligen Stirnfläche erwärmt sich dieselbe sehr gleichmäßig. Es verringert sich hierdurch die Menge des abfließenden Lots. Ferner ist eine besonders gleichmäßige Verteilung des eingebrachten Lotes (Lötzinn) gewährleistet. Beide Kontaktpartner werden besonders gut mit dem Lot benetzt. Die Gefahr eines Einschlusses von Sauerstoff (Luftblasenbildung) und die hiermit verbundene Bildung von wärmeübergangshemmenden Oxidschichten wird stark verringert. Somit wird das Bauelement 2 besonders wirksam gekühlt.

Die weiteren Teile der Steuergeräte 20 (Figur 2) und 30 (Figur 3) haben die gleichen Bezugszeichen wie das Steuergerät 1 von Figur 1. Sie sind gegenüber diesem insoweit unverändert.

## Patentansprüche

1. Steuergerät (1) mit einem elektrischen Bauelement (2), in dem Wärme erzeugt wird, die über ein längliches Metallteil (10) abgeführt wird, dessen eine Stirnfläche (12) mit dem Bauelement (2) verlötet ist, **dadurch gekennzeichnet, dass** die dem Bauelement (2) zugewandte Stirnfläche (12) nach außen gewölbt ausgebildet ist.

2. Steuergerät (1) nach Anspruch 1, **dadurch gekennzeichnet, dass** die dem Bauelement (2) zugewandte Stirnfläche (12) mit einer Riffelung (24) versehen ist.

3. Steuergerät nach einem der vorhergehenden Ansprüche, **dadurch gekennzeichnet, dass** ein peripherer Kontakt des Metallteils (10) mit einer mit dem länglichen Metallteil (10) in enger Berührung stehenden Grundplatte (6) besteht.

4. Steuergerät nach einem der vorhergehenden Ansprüche, **dadurch gekennzeichnet, dass** das Metallteil (10) als Niet ausgebildet ist.

5. Steuergerät nach dem vorhergehenden Anspruch, **dadurch gekennzeichnet, dass** das Niet aus Kupfer hergestellt ist.

## Claims

1. Control device (1), having an electrical component (2) in which heat is generated, said heat being dissipated over an elongated metal part (10) whose one face (12) is soldered to the component (2), **characterized in that** the face (12) oriented towards the component (2) is designed such that it is outwardly arched.

2. Control device according to Claim 1, **characterized in that** the face (12) oriented towards the component (2) is provided with a ribbing (24).

3. Control device according to one of the preceding claims, **characterized in that** the metal part (10) is in peripheral contact with a base plate (6) which is in close contact with the elongate metal part (10).

4. Control device according to one of the preceding claims, **characterized in that** the metal part (10) is designed as a rivet.

5. Control device according to the preceding claim, **characterized in that** the rivet is produced from copper.

## Revendications

1. Appareil de commande (1 ) comprenant un composant électrique (2) dans lequel de la chaleur est générée, celle-ci étant dissipée par une pièce métallique allongée (10) dont la face frontale (12) est brasée avec le composant (2), **caractérisé en ce que** la face frontale (12) tournée vers le composant (2) est courbée vers l'extérieur.

2. Appareil de commande (1) selon la revendication 1, **caractérisé en ce que** la face frontale (12) tournée vers le composant (2) est prévue avec un striage (24).

3. Appareil de commande selon l'une quelconque des revendications précédentes, **caractérisé en ce que** la pièce métallique (10) a un contact périphérique avec une plaque de base (6) qui est en étroit contact avec la pièce métallique (10) allongée.

4. Appareil de commande selon l'une quelconque des revendications précédentes **caractérisé en ce que** la pièce métallique (10) est formée comme un rivet.

5. Appareil de commande selon la revendication précédente, **caractérisé en ce que** le rivet est en cuivre.
